# EUROPEAN PATENT APPLICATION

(11) **EP 3 355 276 A1**
(43) Date of publication of application: **01.08.2018**
(21) Application number: 15904788.5
(22) Date of filing: 06.11.2015
(51) Int. Cl.: G06T 17/00

(54) **METHOD, SYSTEM AND COMPUTER READABLE RECORDING MEDIUM FOR PROVIDING INFORMATION ON MODELING OF STRUCTURE**

(30) Priority: 25.09.2015 KR 20150136353
(71) Applicant: Dongwoo Engineering&Construction Co., Ltd., Gumi-si, Gyeongsangbuk-do 39312 (KR); Kookmin University Industry Academy Cooperation Foundation, Seoul 02707 (KR); Hong, Jun Pyo, Seoul 05607 (KR); Kim, Sang Hoon, Gyeongju-si, Gyeongsangbuk-do 38138 (KR)
(72) Inventor: HONG, Jun Pyo, Seoul 05607 (KR); KIM, Sang Hoon, Gyeongju-si Gyeongsangbuk-do 38138 (KR); AHN, Kil Jae, Seoul 06213 (KR)
(74) Representative: RGTH
(86) International application number: PCT/KR2015/011897
(87) International publication number: WO 2017/051977

(57) **Abstract**

According to one aspect of the invention, there is provided a method for providing information on modeling of a structure, comprising the steps of: acquiring three-dimensional exterior scan data for an exterior of a structure and three-dimensional interior scan data for an interior of the structure; matching the three-dimensional exterior scan data and the three-dimensional interior scan data, with respect to at least one feature point common to the three-dimensional exterior scan data and the three-dimensional interior scan data; and generating information on modeling of the structure with reference to a state of the matching between the three-dimensional exterior scan data and the three-dimensional interior scan data.

## Description

### CROSS-REFERENCE TO RELATED APPLICATION(S)

This application is a continuation application of Patent Cooperation Treaty (PCT) international application Serial No. PCT/KR2015/011897, filed on November 6, 2015, which claims priority to Korean Patent Application Serial No. 10-2015-0136353, filed on September 25, 2015. The entire contents of PCT international application Serial No. PCT/KR2015/011897 and Korean Patent Application Serial No. 10-2015-0136353 are hereby incorporated by reference.

### FIELD OF THE INVENTION

The present invention relates to a method, system, and computer-readable recording medium for providing information on modeling of a structure.

### BACKGROUND

Building information modeling (BIM) is a technique for allowing a structure to be modeled in a multidimensional virtual space throughout the entire life cycle thereof, encompassing planning, design, engineering (e.g., structuring, furnishing, electrical work, etc.), construction, maintenance, and demolition thereof. According to the building information modeling technique, it is possible to model specific information on various design elements (e.g., information on bearable load of steel beams supporting the structure, information on thermal efficiency of the structure, etc.) as well as external appearances, so that an eco-friendly energy saving structure having high energy efficiency or using eco-friendly materials, as well as a cutting-edge structure having a complex constitution or special design, may be designed and constructed.

Meanwhile, the building information modeling generally refers to, but not necessarily limited to, modeling of a building, and may also be applied to any other structures that can be modeled (e.g., ships, heavy equipment, vehicles, etc.), as necessary.

In recent years, there has been a growing interest in techniques for examining or measuring existing structures, which have been built before the concept of building information modeling is established, to acquire data for building information modeling of the existing structures. These techniques fall under reverse engineering techniques, and are intended to acquire and generate specific and analytical data that may facilitate enhancing utilization of old structures.

In the conventional techniques, it is common for a person to photograph or measure each part of an existing structure personally in order to obtain data necessary for modeling of the structure. The conventional techniques not only require excessive time and effort, but also cause a problem that it is difficult to guarantee the accuracy of modeling.

In order to solve the above problems, a technique for photographing or scanning each part of a structure using an unmanned aerial vehicle (UAV) or a sensor network has been recently introduced. However, even with the conventional technique, there is a need for a technique capable of accurately and efficiently matching a large amount of data collected for each part of the structure.

### SUMMARY OF THE INVENTION

One object of the present invention is to solve all the above-described problems.

Another object of the invention is to accurately and efficiently construct information on modeling of an existing structure, by acquiring three-dimensional exterior scan data for an exterior of a structure and three-dimensional interior scan data for an interior of the structure; matching the three-dimensional exterior scan data and the three-dimensional interior scan data, with respect to at least one feature point common to the three-dimensional exterior scan data and the three-dimensional interior scan data; and generating information on modeling of the structure with reference to a state of the matching between the three-dimensional exterior scan data and the three-dimensional interior scan data.

The representative configurations of the invention to achieve the above objects are described below.

According to one aspect of the invention, there is provided a method for providing information on modeling of a structure, comprising the steps of: acquiring three-dimensional exterior scan data for an exterior of a structure and three-dimensional interior scan data for an interior of the structure; matching the three-dimensional exterior scan data and the three-dimensional interior scan data, with respect to at least one feature point common to the three-dimensional exterior scan data and the three-dimensional interior scan data; and generating information on modeling of the structure with reference to a state of the matching between the three-dimensional exterior scan data and the three-dimensional interior scan data.

According to another aspect of the invention, there is provided a system for providing information on modeling of a structure, comprising: a scan data processing unit configured to acquire three-dimensional exterior scan data for an exterior of a structure and three-dimensional interior scan data for an interior of the structure, and to match the three-dimensional exterior scan data and the three-dimensional interior scan data, with respect to at least one feature point common to the three-dimensional exterior scan data and the three-dimensional interior scan data; and a modeling information management unit configured to generate information on modeling of the structure with reference to a state of the matching between the three-dimensional exterior scan data and the three-dimensional interior scan data.

In addition, there are further provided other methods and systems to implement the invention, as well as computer-readable recording media having stored thereon computer programs for executing the methods.

According to the invention, it is possible to accurately and efficiently match a large amount of scan data collected for each part of a structure, so that the time and effort required to construct integrated scan data for the structure may be drastically reduced.

According to the invention, it is possible to utilize matched scan data and context information to accurately identify inconspicuous information on a structure as well.

According to the invention, it is possible to perform a safety inspection of an existing structure that lacks modeling data, or a simulation for energy efficiency of the structure, on the basis of analytical and specific information on the structure.

### BRIEF DESCRIPTION OF THE DRAWINGS

FIG. 1 schematically shows the configuration of an entire system for providing information on modeling of a structure according to one embodiment of the invention.
FIG. 2 illustratively shows the internal configuration of a modeling system according to one embodiment of the invention.
FIGS. 3A and 3B illustratively show scan data collected as a result of photographing a structure according to one embodiment of the invention.
FIGS. 4A to 6 illustratively show the configurations for matching scan data according to one embodiment of the invention.
FIGS. 7 to 9 illustratively show images of three-dimensional exterior scan data and three-dimensional interior scan data that may be matched with respect to feature points according to one embodiment of the invention.

### DETAILED DESCRIPTION

In the following detailed description of the present invention, references are made to the accompanying drawings that show, by way of illustration, specific embodiments in which the invention may be practiced. These embodiments are described in sufficient detail to enable those skilled in the art to practice the invention. It is to be understood that the various embodiments of the invention, although different from each other, are not necessarily mutually exclusive. For example, specific shapes, structures and characteristics described herein may be implemented as modified from one embodiment to another without departing from the spirit and scope of the invention. Furthermore, it shall be understood that the positions or arrangements of individual elements within each of the disclosed embodiments may also be modified without departing from the spirit and scope of the invention. Therefore, the following detailed description is not to be taken in a limiting sense, and the scope of the invention, if properly described, is limited only by the appended claims together with all equivalents thereof. In the drawings, like reference numerals refer to the same or similar functions throughout the several views.

Hereinafter, preferred embodiments of the present invention will be described in detail with reference to the accompanying drawings to enable those skilled in the art to easily implement the invention.

### Configuration of an entire system

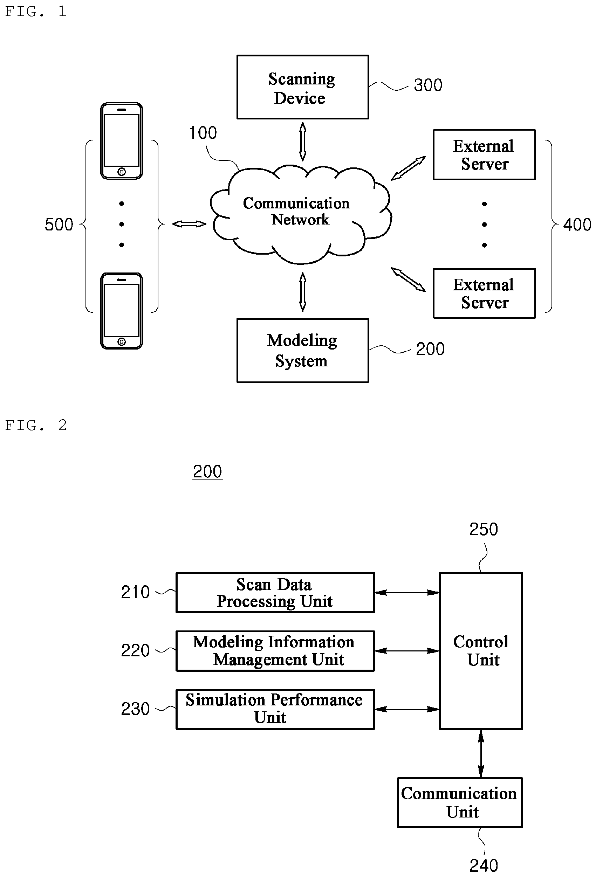

FIG. 1 schematically shows the configuration of an entire system for providing information on modeling of a structure according to one embodiment of the invention.

As shown in FIG. 1, the entire system according to one embodiment of the invention may comprise a communication network 100, a modeling system 200, a scanning device 300, an external server 400, and a user terminal device 500.

First, according to one embodiment of the invention, the communication network 100 may be implemented with a communication scheme encompassing both wired and wireless communications, and may be implemented as a communication network including a mobile communication network. More specifically, the communication network 100 described herein should be understood as encompassing, for example, commonly known WLAN (Wireless LAN), CDMA (Code Division Multiple Access), WCDMA (Wideband Code Division Multiple Access), GSM (Global System for Mobile communications), or LTE (Long Term Evolution) communication networks.

Next, according to one embodiment of the invention, the modeling system 200 may function to accurately and efficiently construct information on modeling of an existing structure, by acquiring three-dimensional exterior scan data for an exterior of a structure and three-dimensional interior scan data for an interior of the structure; matching the three-dimensional exterior scan data and the three-dimensional interior scan data, with respect to at least one feature point (e.g., an opening such as a door and a window) common to the three-dimensional exterior scan data and the three-dimensional interior scan data; and generating information on modeling of the structure with reference to a state of the matching between the three-dimensional exterior scan data and the three-dimensional interior scan data.

The internal configuration of the modeling system 200 will be discussed in more detail in the section "Configuration of the modeling system" below.

Next, according to one embodiment of the invention, the scanning device 300 may function to generate three-dimensional scan data for the exterior or interior of the structure, and an unmanned aerial vehicle (UAV) having a photographing means, a LADAR (laser radar) scanner, or the like may be adopted as the scanning device 300 according to the invention. Further, according to one embodiment of the invention, a photographing device usually used by a general user (e.g., a portable camera or a camera provided in a smart phone) may also be adopted as the scanning device 300 according to the invention. According to one embodiment of the invention, the scanning device 300 may function to provide the modeling system 200 with information on locations where the three-dimensional scan data are generated.

Next, according to one embodiment of the invention, the external server 400 may encompass various servers capable of providing the modeling system 200 with various information that may be referred to in generating (i.e., estimating) the information on modeling of the structure (e.g., information on specifications of the structure or components thereof, relevant regulations, and the like).

Next, the user terminal device 500 according to one embodiment of the invention is digital equipment capable of connecting to and then communicating with the communication network 100, and any type of portable digital equipment having a memory means and a microprocessor for computing capabilities, such as a smart phone, tablet, desktop computer, and notebook computer, may be adopted as the user terminal device 500 according to the invention. Meanwhile, the user terminal device 500 according to one embodiment of the invention may include a necessary program, such as an application, web browser, and widget, for assisting a user to provide three-dimensional scan data to the modeling system 200 or to receive information on modeling of a structure or information on a simulation performance result from the modeling system 200.

### Configuration of the modeling system

Hereinafter, the internal configuration of the modeling system 200 crucial for implementing the invention and the functions of the respective components thereof will be discussed.

FIG. 2 illustratively shows the internal configuration of the modeling system according to one embodiment of the invention.

Referring to FIG. 2, the modeling system 200 according to one embodiment of the invention may comprise a scan data processing unit 210, a modeling information management unit 220, a simulation performance unit 230, a communication unit 240, and a control unit 250. According to one embodiment of the invention, at least some of the scan data processing unit 210, the modeling information management unit 220, the simulation performance unit 230, the communication unit 240, and the control unit 250 may be program modules to communicate with an external system (not shown). The program modules may be included in the modeling system 200 in the form of operating systems, application program modules, and other program modules, while they may be physically stored in a variety of commonly known storage devices. Further, the program modules may also be stored in a remote storage device that may communicate with the modeling system 200. Meanwhile, such program modules may include, but not limited to, routines, subroutines, programs, objects, components, data structures, and the like for performing specific tasks or executing specific abstract data types as will be described below in accordance with the invention.

First, according to one embodiment of the invention, the scan data processing unit 210 may function to acquire three-dimensional exterior scan data for an exterior of a structure to be modeled and three-dimensional interior scan data for an interior of the structure, respectively.

According to one embodiment of the invention, the three-dimensional scan data for the interior of the structure may be acquired by merging a plurality of partial scan data generated as a result of photographing or scanning the interior of the structure at each of a plurality of points in an interior space of the structure. Further, according to one embodiment of the invention, the three-dimensional scan data for the exterior of the structure may be acquired by merging a plurality of partial scan data generated as a result of photographing or scanning the exterior of the structure at each of a plurality of points in an exterior space of the structure.

More specifically, according to one embodiment of the invention, the plurality of partial scan data generated as above may include additional data on locations where the corresponding partial scan data are generated, respectively. The scan data processing unit 210 or another component communicating with the scan data processing unit 210 may merge the plurality of partial scan data with reference to the above additional data on the locations, thereby generating the three-dimensional exterior scan data or three-dimensional interior scan data in a single piece.

For example, the above partial scan data may be generated by a photographing means or scanning means provided in an UAV that may be freely located at any point in a three-dimensional space.

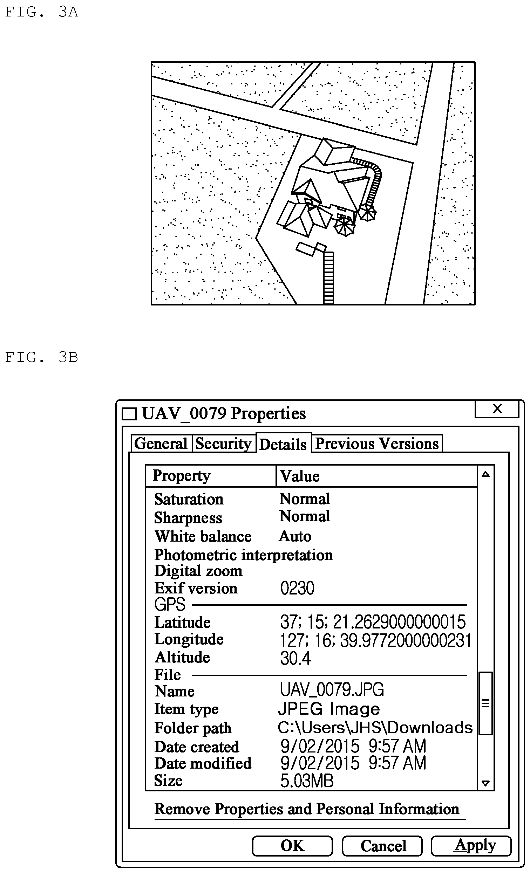

FIGS. 3A and 3B illustratively show scan data collected as a result of photographing a structure according to one embodiment of the invention.

Referring to FIGS. 3A and 3B, partial scan data may be acquired as a result of photographing an exterior of a structure to be modeled by a photographing means provided in an unmanned aerial vehicle floating in the air (see FIG. 3A), and the partial scan data may include additional data on locations (i.e., latitudes, longitudes, and altitudes) where the corresponding partial scan data are generated (see FIG. 3B) .

Further, according to one embodiment of the invention, the modeling information management unit 220 may function to match the three-dimensional exterior scan data and the three-dimensional interior scan data, with respect to at least one feature point common to the three-dimensional exterior scan data and the three-dimensional interior scan data. Here, according to one embodiment of the invention, the feature point may include an opening such as a door, a window, and a passage entrance or exit. However, the feature point described herein is not necessarily limited to the foregoing, and it is noted that any feature point found in common between the three-dimensional exterior scan data and three-dimensional interior scan data of the structure may be utilized as the feature point with respect to which the matching according to the invention is performed.

Specifically, according to one embodiment of the invention, the modeling information management unit 220 may recognize shapes of feature points (e.g., border shapes of doors or windows) appearing in the three-dimensional exterior scan data, and shapes of feature points appearing in the three-dimensional interior scan data, respectively, and may find at least one feature point common to the three-dimensional exterior scan data and the three-dimensional interior scan data, with reference to the recognized shapes of the feature points.

Therefore, according to the invention, the three-dimensional exterior scan data and three-dimensional interior scan data separately generated from the exterior and interior of the structure may be integrated into one piece of unified scan data, and consequently, the complete scan data for the entire structure including both the exterior and interior may be obtained.

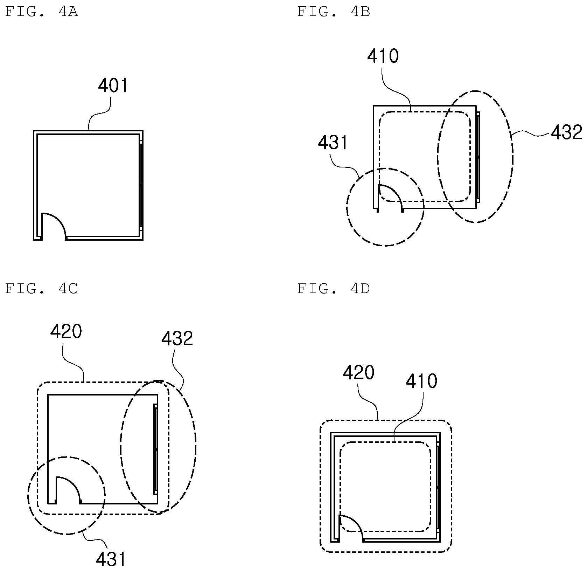

FIGS. 4A to 4D illustratively show the configuration for matching scan data according to one embodiment of the invention.

Referring to FIGS. 4A to 4D, three-dimensional interior scan data 410 obtained as a result of photographing or scanning an interior of a structure 401 to be modeled may be matched (or aligned) with three-dimensional exterior scan data 420 obtained as a result of photographing or scanning an exterior of the structure 401, with respect to their common openings, i.e., a door 431 and a window 432.

Meanwhile, according to one embodiment of the invention, it may be assumed that the three-dimensional interior scan data include first area scan data for a first area inside the structure, and second area scan data for a second area inside the structure (which is distinguished from the first area). In this case, the first area scan data may be acquired by merging a plurality of partial scan data generated as a result of photographing or scanning at each of a plurality of points in the first area inside the structure, and the second area scan data may be acquired by merging a plurality of partial scan data generated as a result of photographing or scanning at each of a plurality of points in the second area inside the structure. According to one embodiment of the invention, the scan data processing unit 210 may function to match the first area scan data and the second area scan data with respect to at least one feature point common to the first area scan data and the second area scan data, thereby completing the three-dimensional interior scan data for the structure.

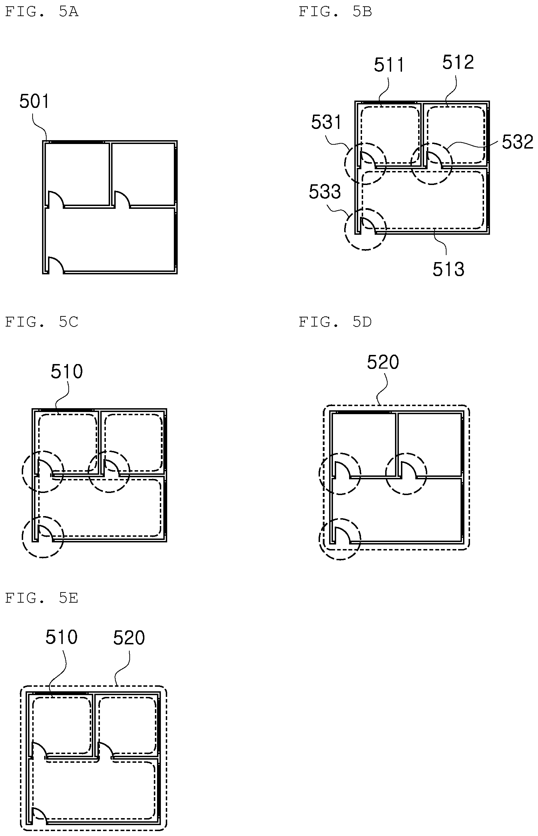

FIGS. 5A to 5E illustratively show the configuration for matching scan data according to one embodiment of the invention.

First, referring to FIGS. 5A to 5C, first area scan data 511, second area scan data 512, and third area scan data 513, which are obtained as a result of photographing or scanning each of first, second, and third areas disposed horizontally in an interior space of a structure 501 to be modeled, may be matched and merged with respect to their common openings, i.e., doors 531 and 532, and consequently, three-dimensional interior scan data 510 for the entire interior space of the structure 501 may be generated.

Next, referring to FIGS. 5D and 5E, the three-dimensional interior scan data 510 generated for the interior of the structure 501 to be modeled may be matched (or aligned) with three-dimensional exterior scan data 520 obtained as a result of photographing or scanning an exterior of the structure 501, with respect to their common opening, i.e., a door 533.

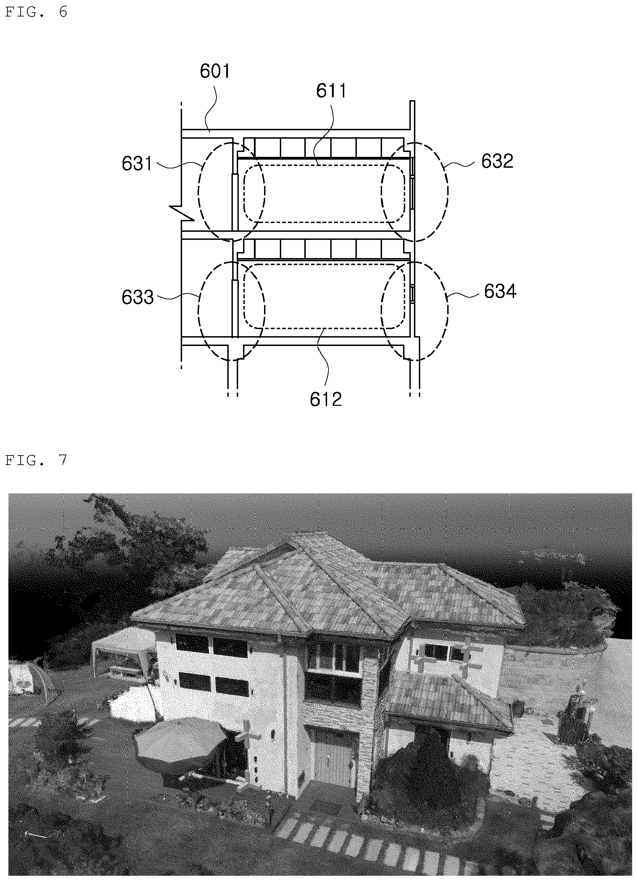

FIG. 6 illustratively shows the configuration for matching scan data according to one embodiment of the invention.

Referring to FIG. 6, first area scan data 611 and second area scan data 612, which are obtained as a result of photographing or scanning each of first and second areas disposed vertically in an interior space of a structure 601 to be modeled, may be matched and merged with respect to their common openings, i.e., doors 631 and 633 and windows 632 and 634, and consequently, three-dimensional interior scan data for the entire interior space of the structure 601 may be generated.

FIGS. 7 to 9 illustratively show images of three-dimensional exterior scan data and three-dimensional interior scan data that may be matched with respect to feature points according to one embodiment of the invention.

First, referring to FIG. 7, an opening such as a window serving as a matching reference (see cross-shaped icons in FIG. 7) may be recognized in three-dimensional exterior scan data generated as a result of photographing or scanning an exterior of a structure to be modeled.

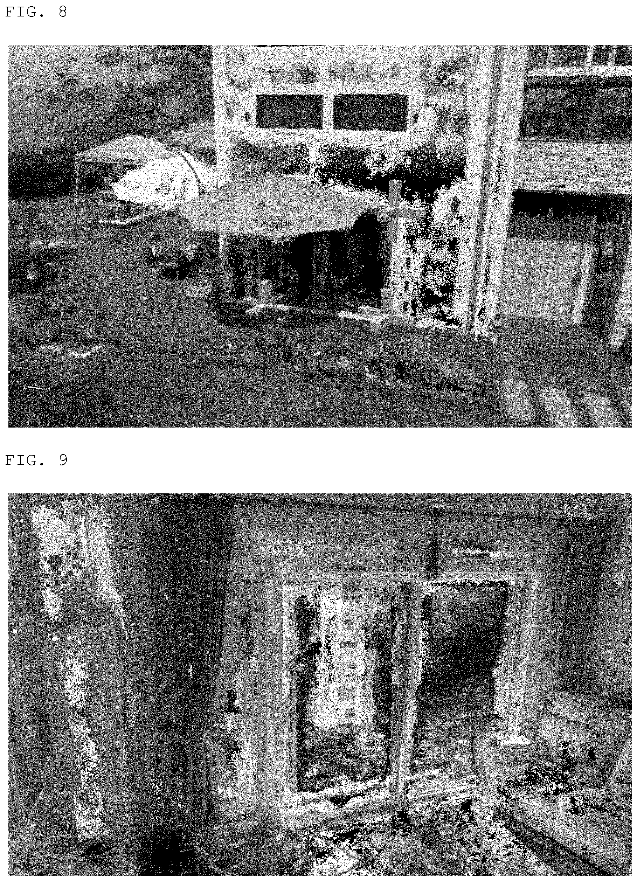

Next, referring to FIGS. 8 and 9, three-dimensional exterior scan data and three-dimensional interior scan data for a structure to be modeled may be matched with respect to a first-floor window (see cross-shaped icons in FIGS. 8 and 9), which is a feature point recognized in both the three-dimensional exterior scan data and three-dimensional interior scan data for the structure.

Next, according to one embodiment of the invention, the modeling information management unit 220 may function to generate (i.e., estimate) information on modeling of the structure with reference to a state of the matching between the three-dimensional exterior scan data and the three-dimensional interior scan data. Here, the information on modeling of the structure may include BIM (Building Information Modeling) information of the structure.

Specifically, according to one embodiment of the invention, the modeling information management unit 220 may generate the information on modeling of the structure with further reference to context information on the structure. Here, the context information may include information on a type of the structure, a location of the structure, locations where the three-dimensional exterior scan data or the three-dimensional interior scan data are generated, and relevant regulations for the structure. However, the context information according to the invention is not necessarily limited to the foregoing, and it is noted that any information that may be referred to in generating the information on modeling of the structure may be utilized as the context information, as long as the objects of the invention may be achieved.

For example, it may be assumed that modeling information on a thickness of insulation in outer walls of a building to be modeled is generated.

In this case, the modeling information management unit 220 according to one embodiment of the invention may recognize that a thickness of the outer walls of the building is 200 mm, with reference to a state of the matching between three-dimensional interior scan data and three-dimensional exterior scan data for the building. Moreover, with further reference to context information on a location where the scan data for the building have been generated (i.e., a location of the building), specifications of energy-saving design standards according to the location of the building, and the like, the modeling information management unit 220 according to one embodiment of the invention may estimate a thickness of the insulation in the 200-mm thick outer walls of the building, which is located at a latitude of 37 degrees 15 minutes 21.263 seconds and a longitude of 127 degrees 16 minutes 39.977 seconds east, in view of the specifications.

Next, according to one embodiment of the invention, the simulation performance unit 230 may function to perform various simulations for a safety inspection or energy efficiency qualification of the structure and to provide results thereof, using the modeling information on the structure generated by the modeling information management unit 220.

Specifically, according to one embodiment of the invention, the simulation performance unit 230 may process the modeling information on the structure generated by the modeling information management unit 220 to conform to a known format such as gbXML (Green Building XML), in order to perform a simulation for the structure.

Next, the communication unit 240 according to one embodiment of the invention may function to enable the modeling system 200 to communicate with an external device.

Lastly, the control unit 250 according to one embodiment of the invention may function to control data flow among the scan data processing unit 210, the modeling information management unit 220, the simulation performance unit 230, and the communication unit 240. That is, the control unit 250 may control inbound data flow or data flow among the respective components of the modeling system, such that the scan data processing unit 210, the modeling information management unit 220, the simulation performance unit 230, and the communication unit 240 may carry out their particular functions, respectively.

Although the embodiments for generating information on modeling of buildings have been mainly described above, it is noted that the present invention is not necessarily limited to the above embodiments, and embodiments for generating information on modeling of any other structures (e.g., ships, heavy equipment, vehicles, etc.) whose exterior and interior scan data may be matched may also be feasible without limitation, as long as the objects of the invention may be achieved.

The embodiments according to the invention as described above may be implemented in the form of program instructions that can be executed by various computer components, and may be stored on a computer-readable recording medium. The computer-readable recording medium may include program instructions, data files, data structures and the like, separately or in combination. The program instructions stored on the computer-readable recording medium may be specially designed and configured for the present invention, or may also be known and available to those skilled in the computer software field. Examples of the computer-readable recording medium include the following: magnetic media such as hard disks, floppy disks and magnetic tapes; optical media such as compact disk-read only memory (CD-ROM) and digital versatile disks (DVDs); magneto-optical media such as floptical disks; and hardware devices such as read-only memory (ROM), random access memory (RAM) and flash memory, which are specially configured to store and execute program instructions. Examples of the program instructions include not only machine language codes created by a compiler or the like, but also high-level language codes that can be executed by a computer using an interpreter or the like. The above hardware devices may be configured to operate as one or more software modules to perform the processes of the present invention, and vice versa.

Although the present invention has been described above in terms of specific items such as detailed elements as well as the limited embodiments and the drawings, they are only provided to help more general understanding of the invention, and the present invention is not limited to the above embodiments. It will be appreciated by those skilled in the art to which the present invention pertains that various modifications and changes may be made from the above description.

Therefore, the spirit of the present invention shall not be limited to the above-described embodiments, and the entire scope of the appended claims and their equivalents will fall within the scope and spirit of the invention.

## Claims

1. A method for providing information on modeling of a structure, comprising the steps of:
acquiring three-dimensional exterior scan data for an exterior of a structure and three-dimensional interior scan data for an interior of the structure;
matching the three-dimensional exterior scan data and the three-dimensional interior scan data, with respect to at least one feature point common to the three-dimensional exterior scan data and the three-dimensional interior scan data; and
generating information on modeling of the structure with reference to a state of the matching between the three-dimensional exterior scan data and the three-dimensional interior scan data.

2. The method of Claim 1, wherein the three-dimensional exterior scan data or the three-dimensional interior scan data are acquired by merging a plurality of partial scan data generated as a result of photographing or scanning the structure at each of a plurality of points.

3. The method of Claim 1, wherein the feature point includes at least one of a door, a window, and a passage entrance or exit.

4. The method of Claim 1, wherein the acquiring step comprises the steps of:
acquiring first area scan data for a first area inside the structure, and second area scan data for a second area inside the structure, respectively; and
matching the first area scan data and the second area scan data with respect to at least one feature point common to the first area scan data and the second area scan data, thereby generating the three-dimensional interior scan data.

5. The method of Claim 1, wherein the information on modeling of the structure includes BIM (Building Information Modeling) information of the structure.

6. The method of Claim 1, wherein in the generating step, the information on modeling of the structure is generated with further reference to context information on the structure.

7. The method of Claim 6, wherein the context information includes information on at least one of a type of the structure, a location of the structure, locations where the three-dimensional exterior scan data or the three-dimensional interior scan data are generated, and relevant specifications or regulations for the structure.

8. The method of Claim 1, further comprising the step of:
performing a simulation for at least one attribute of the structure, with reference to the generated information on modeling of the structure.

9. A computer-readable recording medium having stored thereon a computer program for executing the method of Claim 1.

10. A system for providing information on modeling of a structure, comprising:
a scan data processing unit configured to acquire three-dimensional exterior scan data for an exterior of a structure and three-dimensional interior scan data for an interior of the structure, and to match the three-dimensional exterior scan data and the three-dimensional interior scan data, with respect to at least one feature point common to the three-dimensional exterior scan data and the three-dimensional interior scan data; and
a modeling information management unit configured to generate information on modeling of the structure with reference to a state of the matching between the three-dimensional exterior scan data and the three-dimensional interior scan data.
